# FASCICULE DE BREVET EUROPEEN

(11) **EP 3 362 505 B1**
(45) Date de publication et mention de la délivrance du brevet: **03.08.2022**
(21) Numéro de dépôt: 16791658.4
(22) Date de dépôt: 13.10.2016
(51) Int. Cl.: B32B 5/02, B32B 5/26, B64D 45/02, H01B 1/22, C08J 5/24, C08K 3/08, C08J 5/04

(54) **PROCÉDÉ DE FABRICATION D'UN MATÉRIAU COMPOSITE CONDUCTEUR ET MATÉRIAU COMPOSITE AINSI OBTENU**
VERFAHREN ZUR HERSTELLUNG EINES LEITFÄHIGEN VERBUNDMATERIALS UND SO ERHALTENES VERBUNDMATERIAL
METHOD FOR PRODUCING A COMPOSITE CONDUCTIVE MATERIAL AND COMPOSITE MATERIAL OBTAINED IN THIS WAY

(30) Priorité: 13.10.2015 FR 1559719
(43) Date de publication de la demande: 22.08.2018
(73) Titulaire: Arkema France, 92700 Colombes (FR)
(72) Inventeur: AUDENAERT, Marc, 23700 Bernay (FR); HUZE, Denis, 27120 Fontaine Sous Jouy (FR)
(74) Mandataire: Renard, Emmanuelle
(86) Numéro de dépôt international: PCT/FR2016/052641
(87) Numéro de publication internationale: WO 2017/064423

(56) Documents cités:
- EP-A2- 2 371 529
- US-A- 5 965 064
- US-A1- 2006 111 470
- US-A1- 2012 279 781
- BRODOCEANU D ET AL: "Fabrication of metal nanoparticle arrays by controlled decomposition of polymer particles;Fabrication of metal nanoparticle arrays by controlled decomposition of polymer particles", NANOTECHNOLOGY, IOP, BRISTOL, GB, vol. 24, no. 8, 5 février 2013 (2013-02-05), page 85304, XP020241585, ISSN: 0957-4484, DOI: 10.1088/0957-4484/24/8/085304

## Description

### OBJET DE L'INVENTION

La présente invention concerne un procédé de fabrication d'un matériau composite conducteur, ainsi que le matériau composite susceptible d'être obtenu suivant ce procédé.

### ARRIERE-PLAN DE L'INVENTION

Les matériaux polymères présentent un intérêt certain dans de nombreuses applications, en raison de leur légèreté. Leurs propriétés mécaniques peuvent en outre être ajustées en leur incorporant différentes charges et notamment des fibres de renfort telles que des fibres de carbone. Les composites obtenus remplacent ainsi avantageusement les métaux dans de nombreuses applications. On estime ainsi qu'aujourd'hui les matériaux composites représentent plus de 25% de la masse de la structure d'un Airbus A380 où ils ont supplanté les alliages d'aluminium.

Toutefois, la conductivité électrique de ces composites à base de fibres de carbone est bien inférieure à celle des métaux. Ces fibres ont en effet pour inconvénient de créer, au sein du matériau, un chemin conducteur qui est fonction de leur orientation. Cet inconvénient est particulièrement prononcé dans le cadre des structures stratifiées typiquement utilisées dans le domaine aéronautique, qui présentent une capacité insuffisante à dissiper le courant électrique dans la direction orthogonale aux plans des plis de fibres, la conductivité électrique dans cette direction étant typiquement proche de celle du polymère non conducteur. Ces structures ne résistent donc pas suffisamment à la foudre. En effet, un avion frappé par la foudre doit pouvoir évacuer et donc conduire un courant de l'ordre de 10⁵ ampères, sans que des différences de potentiel trop importantes puissent apparaître, susceptibles d'entraîner une délamination des structures composites précitées et de graves dommages pour les appareils électroniques embarqués. Il est donc nécessaire d'améliorer la conductivité électrique de ces structures pour qu'elle se rapproche de celles du cuivre ou de l'aluminium dans la direction de l'empilement des plis.

Pour remédier aux inconvénients précités, il a été suggéré de disperser des particules conductrices dans la matrice polymère destinée à imprégner les fibres de carbone (EP 2 371 529 et EP 2 687 557). Ces particules conductrices sont destinées à créer des ponts électriques de part et d'autre du matériau composite obtenu. Elles peuvent être constituées d'un matériau carboné, tel que du noir de carbone, ou de particules de verre ou de PMMA revêtues de métal conducteur. Outre les problèmes de manipulation inhérents à l'utilisation de nano-charges telles que le noir de carbone, ces particules conductrices sont généralement difficiles à disperser de manière homogène au sein d'une matrice polymère en raison de leur différence de densité avec le polymère fondu. On comprend donc que l'inclusion de ces particules au sein de la matrice polymère peut compliquer la formulation de cette dernière. En outre, les quantités de charges nécessaires pour atteindre le seuil de percolation, au-delà duquel le matériau composite est conducteur, peuvent affecter négativement certaines propriétés mécaniques du matériau.

D'autres matrices polymères intégrant des particules conductrices composites de type cœur-écorce sont décrites dans les documents US-5,965,064 et US 2012/279781. La publication de Brodoceanu et al. dans Nanotechnology, Vol. 24, n°8 (5 février 2013) décrit par ailleurs l'utilisation de particules composites conductrices de type cœur-écorce dans la formation d'un réseau métallique conducteur.

La mise au point de matériaux composites conducteurs à base de polymères présente également un intérêt dans d'autres secteurs industriels que l'aéronautique, et notamment dans la fabrication de boîtiers destinés à protéger des dispositifs électroniques contre les charges électrostatiques.

Dans la recherche de solutions visant à rendre des matrices polymères conductrices, il a également été suggéré de leur incorporer des nanotubes de carbone. Ces charges présentent des problèmes de dispersion accentués par rapport aux charges conductrices discutées précédemment, en raison de leur structure enchevêtrée. En outre, bien que la concentration de nanotubes nécessaire pour atteindre le seuil de percolation soit inférieure à celle d'autres charges, les nanotubes ont tendance, à cette concentration, à augmenter la viscosité de la matrice, ce qui affecte ses propriétés d'écoulement, nécessaires à sa mise en œuvre et limite, là encore, sa formulation.

Il est possible de remédier aux problèmes de dispersion précités et d'augmenter la conductivité électrique du matériau composite en appliquant des nanotubes de carbone ou du noir de carbone autour de particules de polymère, pour former des particules composites conductrices qui seront ensuite agrégées en un matériau composite conducteur, plutôt que de disperser ces charges dans une matrice polymère. Il a ainsi été proposé par Hao et al. dans Materials Chemistry and Physics, Vol. 109, 15-19 (2008) un procédé particulier de revêtement à sec de particules de polyéthylène par des nanotubes de carbone (NTC) ou du noir de carbone, qui est mis en œuvre dans des conditions conduisant à un ramollissement des particules de polymère et à la fixation des charges sur leur surface. Les particules composites obtenues sont ensuite moulées par compression pour former des plaques.

Bien qu'il présente certains avantages, ce procédé ne permet pas de s'affranchir des problèmes de manipulation des nanocharges et de leur possible impact sur l'environnement. Il subsiste donc le besoin de disposer d'un procédé alternatif à celui décrit ci-dessus.

Le document JP2006-111470 décrit un procédé alternatif dans lequel des particules composites à coeur polymère et écorce métallique sont soumises à un procédé de soudage sous pression pour les agglomérer. L'épaisseur de l'écorce métallique (supérieure à 300 nm) ne permet pas de faire coalescer les particules, de sorte que de l'air se trouve piégées entre elles et que le métal ne forme pas de chemin conducteur continu au travers du matériau obtenu.

### RESUME DE L'INVENTION

Dans ce contexte, les inventeurs ont mis au point un procédé de fabrication d'un matériau composite utilisant des particules de polymère revêtues de métal, ne nécessitant pas la dispersion de ces particules dans une matrice polymère. Bien que ce procédé et les particules mises en œuvre présentent des similitudes avec ceux décrits par Hao et al., ils s'en distinguent par le fait que les particules composites de Hao et al. présentent une surface constituée d'un agrégat de NTC enchevêtrés ou de particules de noir de carbone agglomérées, et non d'un film continu. Les recherches menées par la Demanderesse ont permis d'ajuster les caractéristiques des particules composites et les étapes du procédé selon l'invention, afin de permettre de concilier deux exigences *a priori* contradictoires pour des particules composites métalliques, à savoir l'utilisation d'une quantité de métal suffisante pour atteindre le seuil de percolation, sans empêcher pour autant la coalescence des particules de polymère au-dessus du point de fusion. En outre, le procédé selon l'invention présente l'avantage de ne pas modifier sensiblement les propriétés mécaniques du polymère, lors de la formation du matériau composite. Il permet enfin de s'affranchir des contraintes de formulation des matrices polymères additivées de l'art antérieur.

L'invention a donc pour objectif de proposer un matériau composite conducteur obtenu à partir d'une matrice polymère, qui offre une bonne conductivité électrique transversale lorsqu'il se présente sous forme de plaque, ainsi que de bonnes propriétés mécaniques, tout en étant de fabrication aisée.

La présente invention a donc pour objet un procédé de fabrication d'un matériau composite conducteur à partir d'une matrice polymère composite, dans lequel la matrice polymère composite est formée par coalescence (agrégation) de particules composites conductrices constituées de particules d'une matrice polymère, ayant un diamètre d50 compris entre 1 et 4.000 µm, enrobées d'une couche de matériau conducteur électrique métallique, lesdites particules n'étant pas dispersées dans une matrice polymère, caractérisé en ce que le ratio de l'épaisseur de ladite couche au diamètre d50 des particules de matrice polymère, tel que mesuré selon la norme ISO 9276, est compris entre 0,0025:100 et 1,5:100, ladite épaisseur étant inférieure à 300 nm, lesdites particules ne comprenant pas d'autre couche.

Elle a également pour objet le matériau composite susceptible d'être obtenu suivant le procédé ci-dessus, qui comprend une matrice polymère composite renfermant un réseau métallique tridimensionnel formant un chemin conducteur continu.

### DESCRIPTION DETAILLEE

Le procédé de fabrication d'un matériau composite selon l'invention est caractérisé en ce qu'il comprend une étape consistant à agréger des particules composites conductrices.

Ces particules peuvent avoir une forme sphérique, sphéroïdale ou non sphérique. Le diamètre de ces particules peut être compris entre 1 et 4.000 µm, de préférence entre 5 et 1.000 µm, plus préférentiellement entre 10 et 500 µm, par exemple entre 30 et 300 µm.

Dans le cadre de cette description, le terme "diamètre" est utilisé pour décrire le diamètre du cercle circonscrit des particules. Le D50 correspond à la valeur de la taille de particule qui divise la population de particules examinée exactement en deux. Autrement dit, 50% des particules ont une taille inférieure au D50. Le D50 est mesuré selon la norme ISO 9276 - parties 1 à 6 : « Représentation de données obtenues par analyse granulométrique ». Dans la présente description, on utilise un granulomètre laser (par exemple de type Malvern) pour obtenir la distribution granulométrique de la poudre et en déduire le D50.

En outre, dans toute cette description, l'expression "compris entre" désigne un intervalle incluant les bornes citées.

Les particules composites conductrices utilisées selon l'invention sont constituées d'un cœur formé d'une matrice polymère, qui est revêtu d'une enveloppe d'au moins un métal conducteur. Elles ne comprennent pas d'autre couche, en particulier de couche extérieure à l'enveloppe, telle qu'une couche polymérique.

La matrice polymère comprend au moins un polymère thermoplastique ou thermodurcissable, qui peut éventuellement présenter des propriétés élastomériques, de préférence un ou plusieurs polymère(s) thermoplastique(s), avantageusement non élastomérique(s).

Des exemples de polymères thermoplastiques comprennent les homo- et copolymères d'oléfines tels que les copolymères acrylonitrile-butadiène-styrène, le polyéthylène, le polypropylène, le polybutadiène et le polybutylène ; les polymères vinyliques tels que le poly(divinylbenzène) et les copolymères éthylène - acétate de vinyle ; les homo- et copolymères acryliques et les poly(méth)acrylates d'alkyles tels que le poly(méthacrylate de méthyle) ; les homo- et copolyamides ; les polycarbonates ; les polyesters dont le poly(téréphtalate d'éthylène) et le poly(téréphtalate de butylène) ; les polyéthers tels que le poly(phénylène éther) et le poly(oxyméthylène) ; le polystyrène et les copolymères styrène / acrylonitrile ; les copolymères de styrène et d'anhydride maléique ; le poly(chlorure de vinyle) ; les polymères fluorés tels que le poly(fluorure de vinylidène), le polytétrafluoréthylène et le polychlorotrifluoroéthylène ; les polyuréthanes thermoplastiques ; la polyétheréthercétone (PEEK) et la polyéthercétonecétone (PEKK) ; le polyétherimide ; la polysulfone ; le poly(sulfure de phénylène) ; l'acétate de cellulose ; et leurs mélanges.

Selon une forme d'exécution préférée de l'invention, le polymère est choisi parmi les polyamides et les polycétones.

Les polyamides comprennent les homopolyamides et les copolyamides.

Parmi les homopolyamides (PA), on peut notamment citer le PA-6, le PA-11 et le PA-12, obtenus par polymérisation d'un aminoacide ou d'un lactame, le PA-6.6, le PA-4.6, le PA-6.10, le PA-6.12, le PA-6.14, le PA 6-18, le PA-10.10 et le PA-10.12, obtenus par polycondensation d'un diacide et d'une diamine, ainsi que les polyamides aromatiques tels que les polyarylamides, obtenus notamment à partir de 1,3-xylylène diamine et/ou de 1,4-xylylène diamine, et les polyphtalamides, obtenus à partir d'acide téréphtalique et/ou isophtalique. Certains des polymères précités sont notamment disponibles auprès de la société ARKEMA sous la dénomination commerciale RILSAN.

Les copolyamides peuvent être obtenus à partir de divers matériaux de départ : (i) lactames, (ii) acides aminocarboxyliques ou (iii) quantités équimolaires de diamines et d'acides dicarboxyliques. L'obtention d'un copolyamide nécessite de choisir au moins deux produits de départ différents parmi ceux cités précédemment. Le copolyamide comprend alors au moins ces deux motifs. Il peut ainsi s'agir d'un lactame et d'un acide aminocarboxylique ayant un nombre différent d'atomes de carbone, ou de deux lactames ayant des masses moléculaires différentes, ou encore d'un lactame combiné à une quantité équimolaire d'une diamine et d'un acide dicarboxylique. Les lactames (i) peuvent être en particulier choisis parmi le lauryllactame et/ou le caprolactame. L'acide aminocarboxylique (ii) est avantageusement choisi parmi les a,w-aminoacides carboxyliques tels que l'acide 11-aminoundécanoïque ou l'acide 12-aminododécanoïque. De son côté, le précurseur (iii) peut notamment être une combinaison d'au moins un diacide carboxylique aliphatique, cycloaliphatique ou aromatique en C6-C36, tel que l'acide adipique, l'acide azélaïque, l'acide sébacique, l'acide brassylique, l'acide n-dodécanedioïque, l'acide téréphtalique, l'acide isophtalique ou l'acide 2,6-naphtalène dicarboxylique avec au moins une diamine aliphatique, cycloaliphatique, arylaliphatique ou aromatique en C4-C22, telle que l'hexaméthylène diamine, la pipérazine, le 2-méthyl-1,5-diaminopentane, la m-xylylène diamine ou la p-xylylène diamine étant entendu que lesdits diacide(s) 11 carboxylique(s) et diamine(s) sont utilisés, lorsqu'ils sont présents, en quantité équimolaire. De tels copolyamides sont notamment commercialisés sous la dénomination commerciale Platamid^{®} par la société ARKEMA.

Selon une forme d'exécution de l'invention, on peut choisir comme polyamide un polyamide semi-aromatique (à base de structure aromatique) et/ou semi-cycloaliphatique (à base de structure cycloaliphatique), de préférence semi-aromatique, plus particulièrement correspondant à l'une des formules suivantes :
- polyamides comprenant des motifs x.T où x est une diamine aliphatique linéaire en C₉ à C₁₈, de préférence en C₉, C₁₀, C₁₁, C₁₂ et où T est l'acide téréphtalique, choisis parmi : 8.T, 9.T, 10.T, 11.T, 12.T, , 6.T/9.T, 9.T/10.T, 9.T/11.T, 9.T/12.T, 9/6.T, 10/6.T, 11/6.T, 12/6.T, 10/9.T, 10/10.T, 10/11.T, 10/12.T, 11/9.T, 11/10.T, 11/11.T, 11/12.T, 12/9.T, 12/10.T, 12/11.T, 12/12.T, 6.10/6.T, 6.12/6.T, 9.10/6.T, 9.12/6.T, 10.10/6.T, 10.12/6.T, 6.10/9.T, 6.12/9.T, 9.10/9.T, 9.12/9.T, 10.10/9.T 10.12/9.T, 6.10/10.T, 6.12/10.T, 9.10/10.T, 9.12/10.T, 10.10/10.T, 10.12/10.T, 6.10/12.T, 6.12/12.T, 9.10/12.T, 9.12/12.T, 10.10/12.T, 11/6.T/9.T, 11/6.T/10.T, 11/6.T/11.T, 11/6.T/12.T, 11/9.T/10.T, 11/9.T/11.T, 11/9.T/12.T, 11/10.T/11.T, 11/10.T/12.T, 11/11.T/12.T, 6.T/10.T, 6.T/11.T, 6.T/12.T, 10.T/11.T, 10.T/12.T, 11.T/12.T, 12/6.T/10.T, 12/6.T/11.T, 12/6.T/12.T, 12/9.T/10.T, 12/9.T/11.T, 12/9.T/12.T, 12/10.T/11.T, 12/10.T/12.T, 12/11.T/12.T,
- polyamides terpolymères précédents avec 12/ remplacé par 9/, 10/, 6.10/, 6.12/, 10.10/, 10.12/, 9.10/ et 9.12/,
- tous les polyamides cités ci-haut où le téréphtalique (T) est remplacé partiellement ou totalement par l'isophtalique (I), le naphtalène 2,6 dicarboxylique et/ou par le 1,3 ou le 1,4 CHDA (acide cyclohexane dicarboxylique), avec tout ou partie des diamines aliphatiques pouvant être remplacées par des diamines cycloaliphatiques.
- tous les polyamides cités ci-haut, avec remplacement de la diamine aliphatique en C₆ à C₁₂ par une diamine cycloaliphatique parmi BMACM, BACM et/ou IPDA et avec remplacement de tout ou partie du diacide aromatique T, par un diacide aliphatique linéaire ou ramifié en C₆ à C₁₈.

Dans un mode de réalisation avantageux de l'invention, on utilise comme polymère thermoplastique un polyamide semi-cristallin ayant une température de transition vitreuse d'au moins 100°C, de préférence d'au moins 120°C et une température de fusion inférieure à 280°C, ces températures étant mesurées par DSC selon la norme ISO 11357. Ce polyamide a de préférence comme formule générale 10.T/A.T où T désigne l'acide téréphtalique et A désigne par exemple la m-xylène diamine (MXDA) ou la 2-méthyl-pentaméthylèhne diamine (MPMDA). Ce polyamide peut être obtenu à partir d'une composition réactive d'au moins un prépolymère, qui est un précurseur dudit polyamide, portant deux fonctions terminales (typiquement NH2 et COOH) co-réactives entre elles par condensation, ou deux fonctions terminales identiques (typiquement NH2 ou COOH) susceptibles de réagir avec les fonctions terminales portées par un autre prépolymère qui lui est mélangé (typiquement COOH ou NH2). En variante, ledit polyamide peut être obtenu par mélange desdits précurseurs en présence d'un allongeur de chaîne monomérique portant deux fonctions terminales du type oxazoline, époxy ou isocyanate.

Comme polymères thermodurcissables, on peut en particulier utiliser les résines époxy, les polyesters insaturés, les résines phénoliques, les résines mélamine-formaldéhyde et les polyimides, pour autant qu'ils se présentent sous forme solide à température ambiante (25°C). Les résines époxy sont préférées pour une utilisation dans cette invention.

Outre les polymères ci-dessus, la matrice polymérique utilisée selon l'invention peut en outre éventuellement contenir un ou plusieurs additifs choisis parmi : les charges électriquement conductrices, les agents durcisseurs, les plastifiants, les lubrifiants, les pigments, les colorants, les stabilisants anti-UV, anti-oxygène et/ou thermiques, les agents anti-chocs, les charges de renfort, les agents antistatiques, les fongicides, les agents ignifugeants et leurs mélanges. Selon une forme d'exécution préférée de l'invention, elle renferme du graphite expansé destiné à améliorer sa conductivité thermique. Les charges de renfort sont des matériaux particulaires sous forme d'inclusions ou de fibres, destinés à améliorer les propriétés de la matrice. Les fibres céramiques, organiques, inorganiques et métalliques, ainsi que les nanotubes de carbone constituent des exemples de tels matériaux. On préfère selon l'invention que la matrice polymérique renferme une ou plusieurs charges électriquement conductrices, telles que le graphite.

Comme indiqué précédemment, les particules utilisées selon l'invention sont enrobées d'une couche de matériau conducteur métallique.

Des exemples de métaux utilisables dans la présente invention comprennent l'argent, l'or, le nickel, le cuivre, le platine, l'étain, le titane, le cobalt, le zinc, le fer, le chrome, l'aluminium, ainsi que leurs alliages, de préférence l'or, l'argent, le nickel, le cuivre, le platine, l'étain et le titane et plus préférentiellement l'argent.

L'application du revêtement métallique sur les particules polymériques peut se faire par différentes méthodes telles que le dépôt physique en phase vapeur (PVD), le dépôt chimique en phase vapeur (CVD) et le dépôt auto-catalytique (placage non électrolytique). On préfère dans cette invention que les particules composites conductrices soient obtenues par dépôt en phase vapeur d'au moins un métal sur la surface des particules de matrice polymère. Dans le procédé de CVD, un composé organométallique peut être chauffé pour passer à l'état de vapeur, puis entraîné dans un réacteur à lit fluidisé contenant les particules de polymère, de manière à décomposer le précurseur organométallique et à déposer le métal sur les particules de polymère. La température et la durée du traitement, ainsi que la quantité de précurseur, permettent de contrôler l'épaisseur du dépôt. Dans le procédé de PVD, un précurseur métallique du métal à déposer peut être évaporé par bombardement d'électrons, effet joule, induction, arc électrique ou faisceau d'ions. En variante, le dépôt du métal peut être effectué par pulvérisation cathodique sous vide ou par dépôt ionique. L'homme du métier saura ajuster les paramètres de ces procédés pour obtenir une couche métallique ayant l'épaisseur voulue. On préfère dans cette invention avoir recours à un procédé de CVD

La quantité de métal déposé sur les particules de matrice polymère peut représenter de 1 à 25% en poids, de préférence de 5 à 20% en poids, par rapport au poids total des particules, pour autant que la couche métallique ait une épaisseur inférieure à 300 nm, mesurée par exemple à l'aide d'un microscope électronique après polissage ionique, selon une technique bien connue de l'homme de l'art, et que le ratio de l'épaisseur de ladite couche au diamètre d50 des particules de matrice polymère, mesuré selon la norme ISO 9276, soit compris entre 0,0025:100 et 1,5:100, de préférence entre 0,005:100 et 1:100 et, mieux, entre 0,1:100 et 0,5:100.

Dans le procédé selon l'invention, les particules composites décrites ci-dessus sont agrégées, de préférence par mise en contact desdites particules dans des conditions de faible cisaillement, à une température à laquelle la matrice polymère est au moins partiellement fondue, de manière à faire coalescer lesdites particules. On obtient ainsi une matrice polymère composite renfermant un réseau métallique tridimensionnel formant un chemin conducteur continu.

On préfère ainsi ne pas utiliser de procédés de compoundage, d'injection ou d'extrusion des particules composites, qui génèrent un cisaillement trop élevé de la poudre.

Cette étape d'agrégation peut en revanche se faire par tout procédé de construction additive de pièces à partir de poudre, et notamment par frittage par laser (SLS) ou avec masque (SMS) ou par moulage par compression des particules pour former un matériau composite. Ce matériau composite peut être directement obtenu à la forme voulue ou, sous réserve que la matrice polymère comprend un polymère thermoplastique, il peut être fondu et remis en forme ultérieurement.

En variante, le procédé selon l'invention peut comprendre une étape d'enduction d'un substrat par les particules composites décrites ci-dessus, réalisée avant ou simultanément à l'étape d'agrégation. Le substrat est avantageusement un substrat fibreux, qui peut être formé à partir de fibres naturelles ou synthétiques telles que des fibres de verre, de carbone, de polymère métallisé et leurs mélanges. Ces fibres peuvent être non tissées ou tissées, tressées ou tricotées de manière quelconque et se présenter sous forme de mèche, de câble, de nappe ou de ruban, par exemple. Dans la présente invention, on préfère que le substrat soit constitué d'une nappe de fibres de carbone. Selon une forme d'exécution, les étapes d'enduction et d'agrégation peuvent être réalisées simultanément par trempage en lit fluidisé. Dans ce cas, le substrat est porté à une température supérieure à la température de fusion du polymère formant le cœur des particules, avant que ces dernières ne soient appliquées sur sa surface. Selon une autre forme d'exécution, l'étape d'enduction peut être une étape d'imprégnation à sec du substrat, notamment par projection électrostatique, et l'étape d'agrégation peut alors comprendre le traitement thermique du substrat imprégné, par exemple au moyen d'un chauffage par infra-rouges ou d'un four à convection.

Dans la variante ci-dessus, le matériau composite obtenu constitue un substrat pré-imprégné qui peut être mis en forme suivant diverses techniques. Notamment, lorsqu'il se présente sous la forme d'une plaque, il peut être consolidé par calandrage, par exemple. En variante, lorsqu'il se présente sous forme de fibres composites, celles-ci peuvent être transformées en pièces de révolution par enroulement filamentaire ou en profilés par pultrusion. Un autre procédé de mise en forme qui peut être mis en œuvre est le procédé de placement de fibres ou de rubans. Les dispositifs permettant la mise en œuvre de ces procédés peuvent inclure des moyens d'enduction et de chauffage (agrégation) permettant de réaliser toutes les étapes du procédé selon l'invention.

On préfère que le substrat pré-imprégné soit constitué d'un pli constitué du substrat fibreux recouvert, généralement sur ses deux faces, du matériau composite selon l'invention. Plusieurs de ces plis peuvent être superposés sur une forme (moule) pour former un stratifié qui est ensuite étuvé. Dans le cas où les particules composites conductrices renferment une résine thermodurcissable, ce stratifié est alors généralement chauffé et comprimé pour faire durcir la résine.

A l'issue de ces étapes d'enduction éventuelle, d'agrégation et généralement de mise en forme, on obtient un matériau composite selon l'invention.

Celui-ci peut notamment être utilisé dans toute application nécessitant une conductivité électrique élevée et notamment pour améliorer le blindage électromagnétique et/ou la protection électrostatique de composants électroniques, ainsi que pour conférer une protection contre la foudre à des pièces aéronautiques, des éoliennes, des bâtiments, des automobiles, des trains ou des bateaux. Dans le domaine aéronautique, le matériau composite selon l'invention peut en particulier être utilisé pour la fabrication de fuselages, d'ailes, d'ailerons, de volets, de capots, de poutres ventrales, d'entrées d'air, de radômes ou de carénages.

### EXEMPLES

L'invention sera mieux comprise à la lumière des exemples suivants, qui sont donnés à titre purement illustratif et n'ont pas pour but de limiter la portée de l'invention, définie par les revendications annexées.

### Exemple 1 : Fabrication d'un film composite

On a obtenu par CVD des particules de polyamide 11 (Rilsan^{®} PA11 fourni par ARKEMA) revêtues d'une couche d'argent représentant de 8 à 10% en poids, par rapport au poids total des particules. Ces particules composites présentaient un diamètre D50 de 100 µm, tel que mesuré par granulométrie laser. L'épaisseur du revêtement métallique était d'environ 150 nm.

Ces particules ont été appliquées par trempage en lit fluidisé sur une plaque en acier siliconée portée à 330°. Le film obtenu présentait une épaisseur de 300 µm. Il a été décollé de la plaque puis analysé au microscope électronique à balayage. On a observé une bonne coalescence des particules et la présence d'un réseau métallique continu au sein du matériau.

La résistance électrique du film a ensuite été mesurée au moyen de la méthode dite à 4 points, qui consiste à tracer la courbe de la tension mesurée en fonction de l'intensité appliquée à l'échantillon, pour quatre valeurs d'intensité différentes. La pente de la droite obtenue correspond à la résistance électrique de surface du film, qui était dans cet exemple de 4 Ohm. Sa résistivité transversale était de 200 Ohm-cm.

### Exemple 2 (comparatif) : Fabrication d'un film composite

Des films composites ont été préparées comme décrit à l'Exemple 1, excepté que la fraction pondérale d'argent était de 15-20% au lieu de 8-10%. Les particules obtenues étaient revêtues d'une couche d'argent ayant une épaisseur de 300 à 400 nm.

Ces films étaient cassants et présentaient un aspect rugueux et poreux. Leur observation au microscope électronique à balayage révélait une coalescence médiocre des grains, qui apparaissaient en outre mélangés à des débris de métal.

### Exemple 3 : Fabrication d'une plaque composite

Quatre renforts en fibres de carbone (Hexcel plain 3K HS à 200 g/m²) de 195 mm de large et 295 mm de long ont été imprégnés par saupoudrage sur leurs deux faces par une poudre de particules de PA11 telles que décrites à l'Exemple 1. Après empilement des quatre plis ainsi obtenu et application d'un adhésif sur les 4 côtés de l'empilement, ce dernier a été thermocompressé. Pour ce faire, il a été mis en place dans un moule de 200 mm de large et 300 mm de long, revêtu d'une feuille de tissu téflonné sur chaque face, puis le moule a été introduit dans une presse Carver dont les plateaux étaient préchauffés à 290°C, la pression appliquée sur les plis étant de 1,7 bar. La température des plateaux a ensuite été abaissée à 250°C puis, après 30 sec, la pression a été portée à 10 bars. Au bout de 15 min, les plateaux ont été refroidis jusqu'à une température d'environ 100°C. Après démoulage, on a obtenu une plaque composite.

La résistivité transversale de ces plaques, mesurée par la méthode dite des quatre points, était d'environ 3.000 Ohm-cm.

## Revendications

1. Procédé de fabrication d'un matériau composite conducteur à partir d'une matrice polymère composite, dans lequel la matrice polymère composite est formée par coalescence de particules composites conductrices constituées de particules d'une matrice polymère, ayant un diamètre d50 compris entre 1 et 4.000 µm, enrobées d'une couche de matériau conducteur électrique métallique, lesdites particules n'étant pas dispersées dans une matrice polymère, **caractérisé en ce que** le ratio de l'épaisseur de ladite couche au diamètre d50 des particules de matrice polymère, tel que mesuré selon la norme ISO 9276, est compris entre 0,0025:100 et 1,5:100, ladite épaisseur étant inférieure à 300 nm, lesdites particules ne comprenant pas d'autre couche.

2. Procédé selon la revendication 1, **caractérisé en ce que** la coalescence des particules est réalisée par mise en contact desdites particules composites dans des conditions de faible cisaillement, à une température à laquelle la matrice polymère est au moins partiellement fondue, de manière à faire coalescer lesdites particules.

3. Procédé selon la revendication 2, **caractérisé en ce que** la coalescence des particules est réalisée par frittage par laser, frittage avec masque ou moulage par compression des particules.

4. Procédé selon la revendication 2, **caractérisé en ce qu'**il comprend en outre une étape d'enduction d'un substrat par lesdites particules, réalisée avant ou simultanément à leur coalescence.

5. Procédé selon la revendication 4, **caractérisé en ce que** les étapes d'enduction et de coalescence sont réalisées simultanément par trempage en lit fluidisé.

6. Procédé selon la revendication 4, **caractérisé en ce que** l'étape d'enduction est une étape d'imprégnation à sec du substrat et **en ce que** l'étape de coalescence comprend le traitement thermique du substrat imprégné.

7. Procédé selon l'une quelconque des revendications 1 à 6, **caractérisé en ce que** la matrice polymère comprend un ou plusieurs polymères thermoplastiques.

8. Procédé selon l'une quelconque des revendications 1 à 7, **caractérisé en ce que** lesdites particules composites conductrices sont obtenues par dépôt en phase vapeur d'au moins un métal sur la surface de particules constituées d'une matrice polymère.

9. Matériau composite susceptible d'être obtenu suivant le procédé selon l'une quelconque des revendications 1 à 8, **caractérisé en ce qu'**il comprend une matrice polymère composite renfermant un réseau métallique tridimensionnel formant un chemin conducteur continu.

## Patentansprüche

1. Verfahren zur Herstellung eines leitfähigen Verbundwerkstoffs aus einer Verbundpolymermatrix, wobei die Verbundpolymermatrix durch Koaleszenz von leitfähigen Verbundteilchen, die aus Teilchen einer Polymermatrix mit einem Durchmesser d50 zwischen 1 und 4000 µm, die mit einer Schicht aus metallischem elektrisch leitendem Material beschichtet sind, bestehen, gebildet wird, wobei die Teilchen nicht in einer Polymermatrix dispergiert werden, **dadurch gekennzeichnet, dass** das Verhältnis der Dicke der Schicht zum Durchmesser d50 der Polymermatrixteilchen gemäß Messung nach ISO-Norm 9276 zwischen 0,0025:100 und 1,5:100 liegt, wobei die Dicke weniger als 300 nm beträgt, wobei die Teilchen keine andere Schicht umfassen.

2. Verfahren nach Anspruch 1, **dadurch gekennzeichnet, dass** das Koaleszieren der Teilchen durchgeführt wird, indem man die Verbundteilchen unter geringer Scherbelastung bei einer Temperatur, bei der die Polymermatrix zumindest teilweise geschmolzen ist, in Kontakt bringt, um die Teilchen zum Koaleszieren zu bringen.

3. Verfahren nach Anspruch 2, **dadurch gekennzeichnet, dass** das Koaleszieren der Teilchen durch Lasersintern, Maskensintern oder Formpressen der Teilchen durchgeführt wird.

4. Verfahren nach Anspruch 2, **dadurch gekennzeichnet, dass** es außerdem einen Schritt des Beschichtens eines Substrats mit den Teilchen umfasst, der vor oder gleichzeitig mit ihrem Koaleszieren durchgeführt wird.

5. Verfahren nach Anspruch 4, **dadurch gekennzeichnet, dass** die Schritte des Beschichtens und Koaleszierens gleichzeitig durch Wirbelschichttauchen durchgeführt werden.

6. Verfahren nach Anspruch 4, **dadurch gekennzeichnet, dass** es sich bei dem Schritt des Beschichtens um einen Schritt des Trockenimprägnierens des Substrats handelt und dass der Schritt des Koaleszierens die Wärmebehandlung des imprägnierten Substrats umfasst.

7. Verfahren nach einem der Ansprüche 1 bis 6, **dadurch gekennzeichnet, dass** die Polymermatrix ein oder mehrere thermoplastische Polymere umfasst.

8. Verfahren nach einem der Ansprüche 1 bis 7, **dadurch gekennzeichnet, dass** die leitfähigen Verbundteilchen durch Gasphasenabscheidung mindestens eines Metalls auf der Oberfläche von aus einer Polymermatrix bestehenden Teilchen erhalten werden.

9. Verbundwerkstoff, der nach dem Verfahren nach einem der Ansprüche 1 bis 8 erhältlich ist, **dadurch gekennzeichnet, dass** er eine Verbundpolymermatrix umfasst, die ein einen kontinuierlichen leitfähigen Weg bildendes dreidimensionales metallisches Netzwerk enthält.

## Claims

1. A process for manufacturing a conductive composite material from a composite polymer matrix, wherein the composite polymer matrix is formed by coalescence of conductive composite particles consisting of particles of a polymer matrix, having a diameter d50 of between 1 and 4000 µm, coated with a layer of electrically conductive metallic material, said particles not being dispersed in a polymer matrix, **characterized in that** the ratio of the thickness of said layer to the diameter d50 of the polymer matrix particles, as measured according to the standard ISO 9276, is between 0.0025:100 and 1.5:100, said thickness being less than 300 nm, wherein said particles do not comprise any other layer.

2. The process as claimed in claim 1, **characterized in that** the coalescence of the particles is carried out by bringing said composite particles into contact under low shear conditions, at a temperature at which the polymer matrix is at least partially molten, so as to make said particles coalesce.

3. The process as claimed in claim 2, **characterized in that** the coalescence of the particles is carried out by laser sintering, mask sintering or compression molding of the particles.

4. The process as claimed in claim 2, **characterized in that** it further comprises a step of coating a substrate with said particles, carried out before or at the same time as the coalescence thereof.

5. The process as claimed in claim 4, **characterized in that** the coating and coalescence steps are carried out simultaneously by fluidized bed dip-coating.

6. The process as claimed in claim 4, **characterized in that** the coating step is a step of dry impregnation of the substrate and **in that** the coalescence step comprises the heat treatment of the impregnated substrate.

7. The process as claimed in any one of claims 1 to 6, **characterized in that** the polymer matrix comprises one or more thermoplastic polymers.

8. The process as claimed in any one of claims 1 to 7, **characterized in that** said conductive composite particles are obtained by vapor deposition of at least one metal on the surface of particles consisting of a polymer matrix.

9. A composite material capable of being obtained according to the process as claimed in any one of claims 1 to 8, **characterized in that** it comprises a composite polymer matrix containing a three-dimensional metallic network forming a continuous conductive pathway.
